# EUROPEAN PATENT SPECIFICATION

(11) **EP 0 381 247 B1**
(45) Date of publication and mention of the grant of the patent: **20.09.1995**
(21) Application number: 90102246.7
(22) Date of filing: 05.02.1990
(51) Int. Cl.: C30B 25/10

(54) **Apparatus and method for epitaxial deposition**
Vorrichtung und Verfahren zur epitaktischen Abscheidung
Appareillage et procédé de déposition épitaxiale

(30) Priority: 03.02.1989 US 306376
(43) Date of publication of application: 08.08.1990
(73) Proprietor: APPLIED MATERIALS, INC., Santa Clara, California 95054-3299 (US)
(72) Inventor: Maloney, James R., San Jose California 95117 (US); Moore, Joseph C., Milpitas California 95035 (US)
(74) Representative: DIEHL GLAESER HILTL & PARTNER

(56) References cited:
- GB-A- 2 089 840
- US-A- 3 862 397
- PATENT ABSTRACTS OF JAPAN, vol. 9, no. 10 (E-290)[1733], 17th January 1985; & JP-A-59 159 526

## Description

The present invention is in the field of silicon wafer fabrication equipment useful in the manufacture of semiconductor devices and relates generally to a method and an apparatus for epitaxial deposition.

Apparatus for depositing an epitaxial layer from a source gas by the chemical vapor deposition (CVD) method especially to improvements in the cooling and ease of servicing of such equipment is used in the fabrication of semiconductor devices on 100 millimeter or larger wafers of silicon. Epitaxial layers are formed on the surfaces of the wafers by beating them to temperatures in the region of 1100 to 1200 degrees Celsius in a bell jar containing a gaseous atmosphere consisting of a hydrogen carrier gas mixed with one or more reactive gases such as a silicon source gas or a dopant source gas.

The CVD process is highly temperature sensitive, such that producing the required high quality epitaxial layers on the surfaces of the wafers while avoiding deposition on the walls of the bell jar requires that the wafers be uniformly heated to a precise temperature while the remainder of the apparatus is maintained at a temperature well below that at which the CVD reaction will occur.

The required heating of the wafers is accomplished by inductively heating the graphite susceptor on which the wafers are supported or by radiant heating with a large array of heating lamps surrounding the bell jar, while an air cooling system cools the walls of the bell jar.

Document JP-A-59 159 526 discloses a vapor growth device having a split lamp furnace in which a reaction tube within the furnace is removed by opening the furnace and laterally displacing the reaction tube therefrom.

In one known type of epitaxial deposition system which is used in the Model 7800 Epitaxial Reactor manufactured by Applied Materials of Santa Clara, California, silicon wafers are supported In a spaced array extending over the surface of a vertically elongated graphite susceptor of polygonal cross-section. A cylindrical quartz bell jar coaxially surrounds the susceptor and confines the required gaseous atmosphere. A large array of heating lamps coaxially surrounds the bell jar over most of its vertical extent to radiantly heat the susceptor and wafers. The susceptor and wafers are rotated during processing, such that the gaseous atmosphere is continuously mixed and heating is uniform.

In order to avoid raising the temperature of the quartz bell jar sufficiently to cause unwanted deposition on the walls of the jar, an air-cooling system is provided. A centrifugal blower drives air along a closed-loop flow path extending from the blower output to the deposition apparatus and returning through an air-to-water heat exchanger to the blower input. In the region of the deposition apparatus, the flow path diverges into a first branch which coaxially envelops the bell jar and flows axially along its surface, and a second branch which passes through slots in the lamp arrays to cool the surfaces of the lamp reflectors.

While this prior-art deposition apparatus has performed very successfully, it could be further improved from two standpoints: (1) Access to the heating lamps for replacement could be made easier; and (2) The effectiveness of the cooling system could be increased by lowering air flow resistance and improving the uniformity of air flow.

With respect to the first of these considerations, the operator is required to assume a crouching position while unfastening the connections to one of the five banks of lamps, and then to reach forward and carefully maneuver the bank out of its position on the apparatus. Since each bank is heavy, and clearance with surrounding portions of the apparatus is close, the removal of a bank is somewhat difficult and tiring.

The design of the air cooling system of the prior art deposition apparatus could be improved by eliminating any complex and convoluted portions of the flow path, including any abrupt changes in the flow direction and cross section of the air flow path. In particular, each of the five banks of lamps of this prior-art apparatus is provided with a separate flow of air from a manifold. Providing more uniform and less restricted air flow to cool the heating lamps would promote a maximum service life with minimum maintenance.

An object of the present invention is therefore to provide an epitaxial deposition apparatus and method having an improved air cooling system.

A further object of the present invention is to provide an epitaxial deposition method and apparatus of the type using radiant heating lamps wherein the accessibility of the heating lamps for servicing is improved.

These objects are solved by the epitaxial deposition apparatus in accordance to independent claim 1, and the method for epitaxial deposition in accordance with independent claim 10.

Further advantageous features are evident from the dependent claims 2 to 9 and 11 to 12, respectively.

The present invention provides an epitaxial deposition apparatus of the type using radiant heating lamps arranged in an array surrounding the epitaxial reaction chamber, wherein the lamp array is coaxially surrounded by an air plenum chamber.

The present invention further provides an epitaxial deposition apparatus of the type using radiant heating lamps disposed in a plurality of banks, wherein each bank is pivotally supported on a pivot axis extending along one edge and is rotatable about said pivot axis to an open position away from its mounted position.

The present invention further provides an epitaxial deposition apparatus according to the preceding aspect in which each lamp bank, once pivoted into its open position, can be translationally slid in a direction parallel to its plane for removal.

The present invention further provides an epitaxial deposition apparatus in which the air-flow path is generally unidirectional.

To the above ends, an epitaxial deposition apparatus according to the present invention has a simplified flow path within which cooling air flows from a centrifugal blower through a smoothly tapered transition to a plenum chamber extending over the top and coaxially around the apparatus. From its entrance point near the top of this plenum chamber, cooling air flows axially downward in the coaxial space between the bell jar and the surrounding lamp array.

Lamp-array cooling air also flows downward in the portion of the plenum chamber coaxially surrounding the lamp array, radially inward through slots between the lamps, and axially downward over the surface of the bell jar. From the bottom of the deposition apparatus, air flows through a smoothly tapered transition to an air-to-water heat exchanger where it is cooled before returning to the blower inlet.

By providing a large plenum chamber extending completely around the outside of the lamp array, variations in pressure and flow rate of the air cooling the lamp array are avoided. Similarly, by providing a single air input near the top of the plenum chamber and a single air outlet coaxial with the lower end of the bell jar, air flow within the deposition apparatus is as nearly unidirectionally downward as possible.

The lamp array which coaxially surrounds the bell jar is formed of a plurality of banks in the form of vertically oriented panels, each containing as many as 15-20 linear, tubular halogen-quartz lamps in a spaced ladder-like array with the axis of each lamp horizontal. Each bank is supported by four trunnions, one trunnion being located at each of the four corners of the bank. An upper and a lower support plate are positioned to receive these trunnions in grooves in each support plate, and to support each bank in a mounted position on the apparatus.

For servicing or replacement of the lamps, each bank can be swung approximately 15 degrees away from its mounted position to an open position by being pivoted about a pivot axis extending along one vertical edge between a pair of trunnions. From this open position, the entire bank can be slid sideways along the grooves in the mounting plates and removed from the apparatus.

The above and other features, objects and advantages of the present invention together with the best mode known to the inventors thereof for carrying out their invention will become clearer by reading the following detailed description of the invention while studying the associated drawing, the various figures of which represent:
Fig. 1 is a cross-sectional view in schematic form of a prior- art epitaxial deposition apparatus;
Fig. 2 is a cross-sectional view in schematic form of an epitaxial deposition apparatus according to the present invention;
Fig. 3 is an elevational view of a lamp bank used in the apparatus of Fig. 2 according to the present invention;
Figs. 3A and 3B are broken- away, detailed views of portions of Fig. 3 taken along lines A-A and B-B, respectively;
Fig. 4 is an elevational view of a support plate structure used to support lamp banks according to the present invention;
Fig. 5 is a top, transverse sectional view of an epitaxial deposition apparatus according to the present invention.

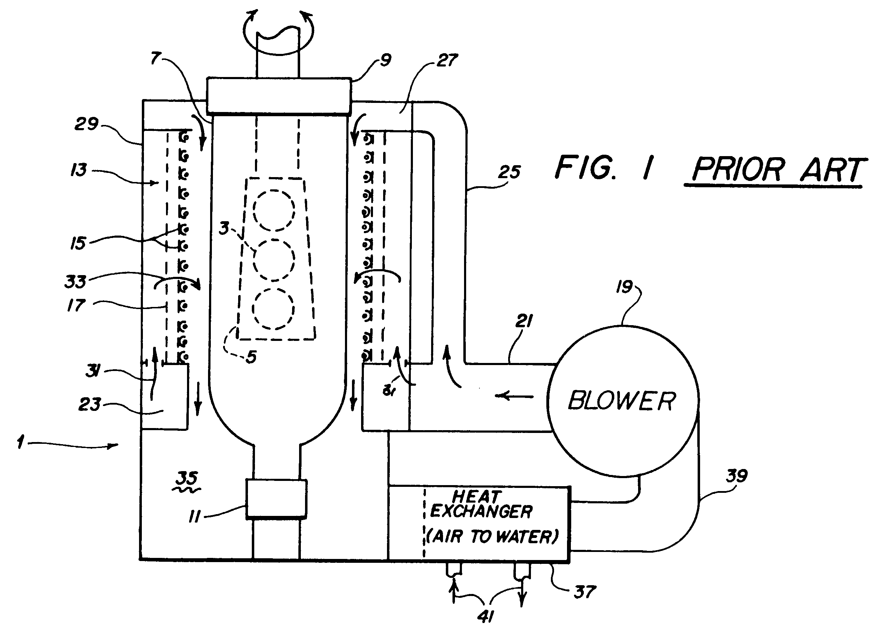

Fig. 1 shows an epitaxial deposition apparatus 1 used for forming epitaxial layers on semiconductor substrates 3 mounted on a graphite susceptor 5 within a quartz bell jar 7. Apparatus 1 is of the prior- art type discussed earlier in this application as used in the aforementioned Applied Materials Model 7800 Epitaxial Reactor system.

Bell jar 7 is supported within apparatus 1 by an upper support 9 and a lower support 11, and is provided with ducts (not shown) for introducing a thermally activated reactive gas mixture to the interior of the bell jar during operation. As Fig. 1 suggests, bell jar 7 may desirably be shaped as a circular cylinder such that it possesses radial symmetry about its central axis.

Coaxially surrounding bell jar 7 is a distributed radiant heater 13 which uses a plurality of heating lamps 15, shown in cross-section, supported on a transversely air-permeable support frame 17. Lamps 15 may be linear, tubular halogen-quartz lamps capable of operation for long periods at temperatures in the region of 3000 degrees Kelvin.

Substrates 3 and susceptor 5 are heated to temperatures in the region of 1100 to 1200 degrees Celsius by heater 13 to cause the thermally activated reactive gas mixture in bell jar 7 to deposit the desired layer on the substrates. For example, such a reactive gas mixture might comprise trichlorosilane gas in a hydrogen carrier gas in order to deposit a silicon epitaxial layer on substrates 3.

In order that the epitaxial layer produced in apparatus 1 be of a desirably high quality and uniformity, the temperature of the substrates 3 must be uniformly raised to the precise temperature needed to activate the chemical vapor depostion (CVD) reaction. Such uniformity is provided by using a distributed heater which produces fairly uniform heating over a large area, by employing a coaxial geometry having radial symmetry, and by continuously rotating substrates 3 and susceptor 5 during processing. The rotation of the susceptor also serves to stir the reactive gas mixture in bell jar 7, maintaining the gases in a thoroughly mixed state.

To avoid unwanted deposition on the walls of bell jar 7, the temperature of these walls must be maintained well below the 1100 to 1200 degree range. In this regard, bell jar 7 is desirably made of quartz, which is capable of withstanding relatively high temperatures and is also relatively transparent to the thermal radiation from heater 13. However, notwithstanding the transparency of bell jar 7, its temperature would eventually rise into the range which would cause unwanted deposition in the absence of a cooling system.

Accordingly, a blower 19 propels a high-volume stream of cooling air through its output duct 21 to cool apparatus 1. The cool air enters a lower input plenum chamber 23 and, via a bypass duct 25, an upper input plenum chamber 27. Chambers 23 and 27 are toroidal in configuration, and extend coaxially around the apparatus.

From upper plenum chamber 27 cooling air flows radially inward and downward along the axis of bell jar 7 to cool the bell jar. From lower plenum chamber 23, cooling air flows upwardly to enter the narrow region of space between the heater support 17 and the adjacent wall 29 of the apparatus, as indicated by arrow 31. As indicated in Fig. 1, arrow 31 extends upwardly through an aperture in the upper wall of plenum chamber 23. The upper wall of lower plenum chamber 23 is provided with a plurality of such apertures azimuthally spaced around chamber 23 to permit such upward flow of cooling air.

Air entering the region of space surrounding the heater 13 passes through slots in heater support 17 as indicated by arrow 33, cooling the heater lamps 15, their associated reflectors and heater support 17 itself. This cooling air then joins the air flowing downwardly from upper input plenum chamber 27 and enters a coaxial output plenum chamber 35.

From output plenum chamber 35, the heated exhaust air from apparatus 1 flows to an air-to-water heat exchanger 37, and returns to blower 19 via an input duct 39. The circulation of water through heat exchanger 37 has been indicated symbolically by arrows 41 in Fig. 1.

The cooling performance of the prior art apparatus 1 of Fig. 1 could be improved by eliminating the somewhat tortuous and complex portions of the air flow path, particularly within that portion of it extending from the lower input plenum chamber 23 to the output plenum chamber 35. Within this portion, the direction of air flow changes by 90 degrees to flow upwardly from chamber 23 through apertures into an isolated and narrow air space behind each of the separate heater banks (not shown) which form heater 13.

This air space is further constricted by electrical conductors (not shown) and water cooling lines (not shown) to the heater lamps 15, and these constrictions result in considerable pressure drops and nonuniformity of air flow through heater support 17. As a result, some of the heater lamps and their reflectors operate at too high a temperature, and the bell jar itself has axial regions in which the temperature exceeds 600 degrees Celsius.

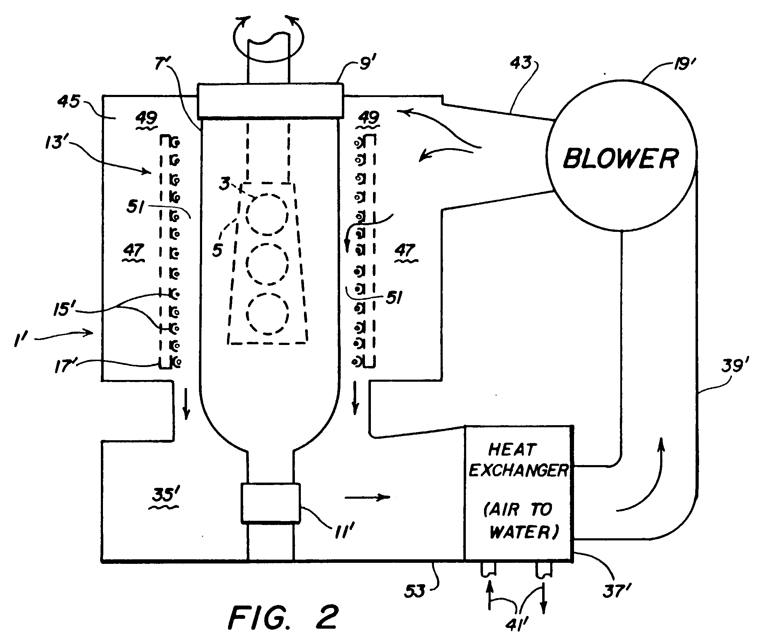

In Fig. 2 an epitaxial deposition apparatus according to the present invention is illustrated using primed reference numerals to indicate parts which are similar to those already described with respect to Fig. 1. Thus, the apparatus 1′ includes a bell jar 7′ coaxially surrounded by a distributed radiant heater 13′ formed of heating lamps 15′ mounted on a heater support 17′. Similarly, an air cooling system including a blower 19′ and an air-to-water heat exchanger 37′ is provided.

However, in accordance with the present invention, the air flow path from the output of blower 19′ through apparatus 1′ and heat exchanger 37′ has been designed to maximize both the magnitude and uniformity of air flow and to minimize air flow resistance. Accordingly, the system has been provided with a tapered input duct 43 connecting the output of blower 19′ to the remainder of apparatus 1′. Each wall of duct 43 has a uniform taper of 7 degrees with respect to the axis of the duct. Such a taper provides an optimally smooth transition from the output of the blower to the remainder of the air flow system and minimizes air pressure drop in duct 43.

A large plenum chamber 45 extends coaxially around and spaced from heater 13′ to define an outer coaxial cooling airspace 47 of sufficient volume to have a relatively uniform air pressure. Plenum chamber 45 also extends without interruption transversely across the top of apparatus 1′ to form an end coaxial cooling airspace 49 which amply interconnects outer coaxial cooling airspace 47 with an inner coaxial cooling airspace 51 between bell jar 7′ and heater 13′.

Cooling air from duct 43 enters plenum chamber 45 near the top end and flows generally downwardly through both coaxial cooling airspaces 47 and 51. Cooling air also flows radially inwardly through end cooling airspace 49 and through the slots in heater support 17′ which make the heater transversely permeable to air flow.

From the lower end of inner coaxial airspace 51, the heated air flows into an output plenum chamber 35′ and passes to an enlarged air-to-water heat exchanger 37′ via a tapered output duct 53. Duct 53 is formed with a 7 degree wall taper as in the case of input duct 43 to minimize flow resistance.

A comparison of the air flow path of Fig. 2 with that of Fig. 1 shows that the flow pattern is much more unidirectional from the point where duct 43 brings cool air into apparatus 1′ to the point where the heated air enters output plenum chamber 35′. In particular, the provision of a high-volume outer coaxial cooling airspace 47 ensures that nearly perfect pressure uniformity is obtained in the region surrounding heater 13′. Further, by making the end coaxial cooling airspace 49 in common with outer coaxial cooling airspace 47, the uniformity of pressure in airspace 49 is improved when compared with the small, isolated, upper plenum chamber 27 of Fig. 1.

As a result of these improvements in the air flow path, it has been found that a system constructed in accordance with Fig. 2 has bell jar temperature readings fully 200 Celsius degrees lower than a system constructed according to Fig. 1 when the two are operated at the same substrate temperature.

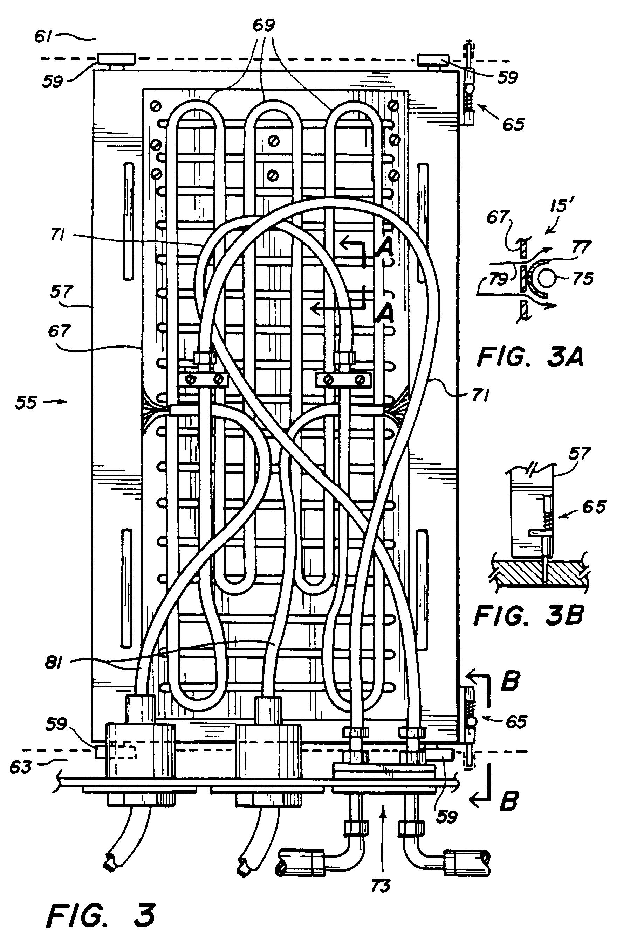

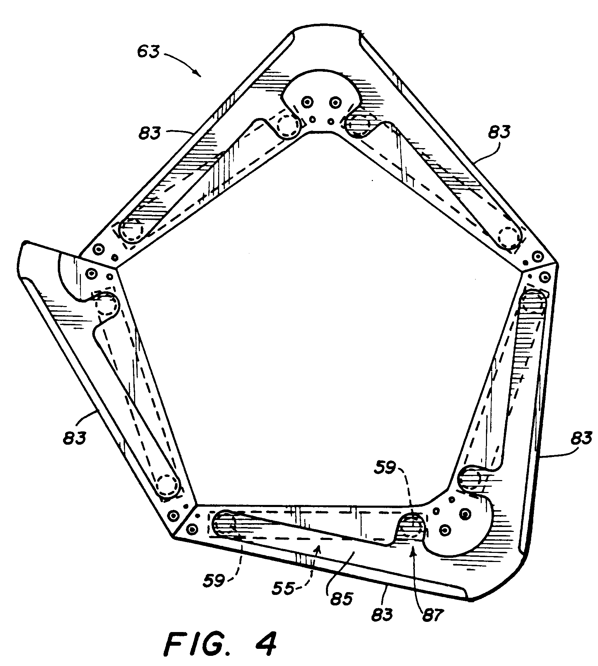

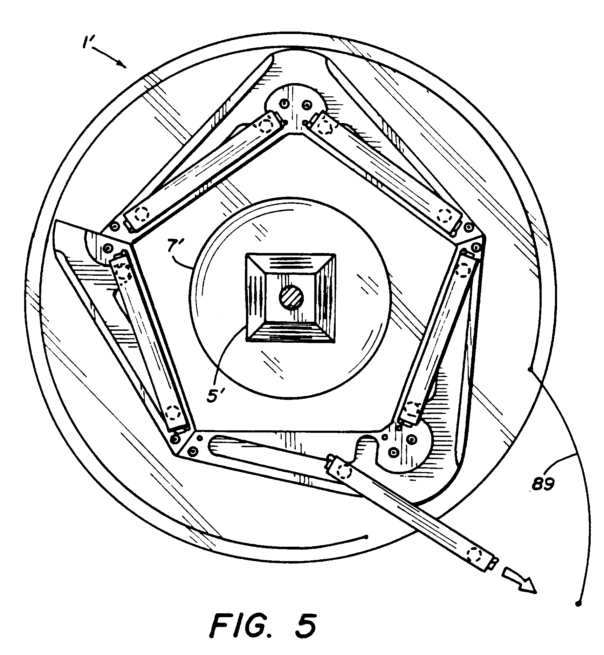

In Fig. 3, a radiant heater bank 55 according to the present invention is shown in a rear view corresponding to its appearance when seen in its operating position on the apparatus 1′ of Fig. 2. In order to form the complete coaxially surrounding heater 13′ of Fig. 2, five heater banks 55 are positioned coaxially around the bell jar 7′ as will become more apparent from a consideration of Figs. 4 and 5 as described below.

Heater bank 55 is formed as a planar panel having an outer rectangular support frame 57 which is mounted on the remainder of the apparatus 1′ by means of four trunnions 59, one at each of the four corners of frame 57. Frame 57 is supported at its upper end by engaging the two trunnions 59 at this end in an upper support rail 61 which is illustrated schematically by a dotted line, and similarly at the lower end of frame 57, where a lower support rail 63 engages the lower two trunnions 59.

A spring-loaded locking bolt 65 is used at the top and bottom ends of frame 57 to secure it in engagement with upper and lower support rails 61 and 63 as will become clearer in consideration of the descriptions of Figs. 4 and 5. Lower bolt 65 has been shown in detail in Fig. 3B, illustrating that it extends into a recess in lower support rail 63.

A slotted backer plate 67 spans the central opening in frame 57 and may be made of .3175 cm (0.125 in.) copper, for example, such that it has excellent thermal conductivity. A serpentine cooling tube 69 extends over the surface of backer plate 67 for the purpose of carrying cooling water in close proximity to all regions of plate 67.

Tube 69 may be made of copper and may desirably be soldered or brazed to plate 67 over all of the region in which it contacts plate 67 for improved thermal conductivity. Flexible coolant tubes 71 connect the ends of tube 69 to a coolant water feedthrough 73 to permit connection to an external source of water (not shown).

Fig. 3A shows in cross section the relationship between backer plate 67 and the heater lamps 15′ which are mounted on the front side (not shown) of bank 55 such that they face toward bell jar 7′ in Fig 2. Each lamp 15′ consists of an elongated linear tubular halogen-quartz bulb 75 supported within a semi-cylindrical reflector 77. Although reflector 77 has been illustrated in Fig. 3 as circular in cross-section for the sake of simplicity, it will be understood that the actual cross-sectional shape of reflector 77 may be a parabola.

As illustrated by arrows 79, cooling air flows through the slots in slotted backer plate 67 and around the lamp reflector positioned between each pair of slots. The heat extracted in this way in addition to the heat extracted from plate 67 by the above-described water cooling system maintains the temperature of the lamps low enough to promote a satisfactory service life.

Electric power to supply each of the lamps 15′ on bank 55 is supplied by a pair of multiconductor cables 81 which contain a pair of wires for each of the lamps 15′ on bank 55. Connections to the lamp terminals (not shown) at the ends of each lamp are made by routing the wire pairs into the surrounding frame 57 as shown.

In Figs. 4 and 5, the details of a support structure for each of five radiant heater banks of the type illustrated in Fig. 3 is shown. Fig. 4 illustrates in plan view the arrangement of lower support rail 63 of Fig. 3, and shows that rail 63 is actually formed of five grooved support plates 83. One heater bank 55 has been illustrated mounted in operating position in each of these support plates, using dotted lines. In the illustrated operating position, the two trunnions 59 at the lower end of each bank 55 occupy positions at the ends of two grooves in each plate 83, where they may be locked in position by locking bolts 65.

As is apparent in Fig. 4, the longer groove 85 is intersected by the shorter groove 87 in such a way that, with bolts 65 withdrawn from engagement with rail 63 and with coolant and electric service disconnected, banks 55 can be rotated away from the operating position about a pivot axis defined by the trunnion 59 at the end of groove 85. With the bank 55 rotated as far as possible, the panel 55 comes to rest in an open position (not illustrated) in which both trunnions 59 are within groove 85.

It will be noted that, in moving a bank 55 from its operating position to its open position, the trunnion at the end of groove 85 does not change its position and merely serves as a pivot point. Throughout the motion from operating position to open position, bank 55 remains fully supported and guided by contact of both of the trunnions 59 with the grooves 85 and 87.

In the open position, a bank 55 can be translationally moved along a translation axis coincident with groove 85 until one trunnion 59 has passed out of groove 85 as illustrated in Fig. 5. At this point bank 55 can be further rotated as convenient while still partially supported by the trunnion 59 remaining in groove 85. Further translational movement of bank 55 will move it to a release position in which both trunnions 59 are free from support rail 63, permitting the removal of the bank 55 from apparatus 1′ through a movable or removable panel 89 for servicing.

In the embodiment of the invention illustrated in Figs. 4 and 5, movement of a bank 55 from operating position into open position involves a rotation through a small angle of, for example, 15 degrees, sufficient to position both trunnions in groove 85 and permit translation therealong. However, it will be understood that by redesigning the support mechanism, it is possible to increase the angle of rotation between operating and open positions. For example, if each bank were to be swung outwardly at a 60 degree angle, servicing of the lamps could be carried out without removing the bank from the apparatus 1′.

Although the above description has discussed the mechanical relationship between each bank and lower support rail 63, it will be understood that upper support rail 61 is formed as a mirror image of lower support rail 61, such that the positions of the trunnions 59 at the upper end of each bank within the grooves of upper support rail 61 are the same as at the lower end of each bank. Accordingly, each bank is guided and support at both of its ends during the operations of removal and replacement. Since each bank may weigh 13.59 kg. (30 lb.), such support, together with the ease of removing and replacing the banks greatly facilitates servicing the heater array when necessary.

Although this invention has been described with some particularity with respect to embodiments thereof which, taken together, comprise the best mode known to the inventors thereof for carrying out their invention, many changes could be made and many alternative embodiments could thus be derived without departing from the scope of the invention, Consequently, the scope of the invention is to be determined only from the following claims.

## Claims

1. An epitaxial deposition apparatus (1') comprising in combination:
a reaction chamber (7') for containing a semiconductor substrate (3) supported on a susceptor (5) and for confining a thermally activated reactive gas therewithin, said reaction chamber having at least a wall portion thereof made of a material which is substantially transparent to thermal radiation within a certain region of wavelengths;
a radiant heater (13') for supplying thermal radiation within said certain region of wavelengths for heating said substrate (3) and susceptor (5); wherein said heater (13') is distributed coaxially around and spaced from said reaction chamber (7') to define a first coaxial cooling airspace (51) therebetween, said heater (13') being radially air-permeable to permit a radial, unidirectional cooling air flow therethrough, said radiant heater (13') including at least one radiant heater bank (55); and
support means (61,63) comprising:
a pair of trunnions (59) disposed on said radiant heater bank (55) and defining a pivot axis extending therebetween;
trunnion-engagement means (85,87) for engaging said pair of trunnions (59) and for constraining motion of said heater bank (55) between a preselected fixed operating position in which said radiant heater bank (55) radiates thermal radiation through said wall portion to heat said substrate (3) and susceptor (5) in said reaction chamber (7') and in which an airspace (51) is provided between said reaction chamber (7') and said heater (13') to allow an airstream cooling said wall; and an open position in which said bank is pivoted about said pivot axis away from said fixed operating position; and
translational support means (83) for translational motion of said bank (55) and for constraining such translational motion along a translation axis from said open position to a release position in which said bank (55) can be lifted free of remaining portions of the apparatus; and for continuously supporting said bank (55) during translational motion between said open and released positions.

2. The apparatus of claim 1 wherein the heater (13') comprises several radiant heater banks (55) arranged one adjacent to the other.

3. The apparatus of claim 2 wherein the heater banks are planar and are arranged in form of a polygon with the reaction chamber (7') being arranged in the center of same.

4. The apparatus of one of claims 1 to 3 further including:
locking means (65) for securing said bank (55) in said fixed operating position, said locking means (65) being selectively operable between a locked position in which said bank (55) is locked in said fixed operating position and a released position in which said bank (55) is movable away from said operating position to said open position.

5. The apparatus of one of claims 1 to 4 wherein said support means (61,63) supports said bank (55) continuously during motion between said operating and open positions.

6. The apparatus of one of claims 1 to 3 wherein said support means (61,63) constrains motion of said heater bank (55) between said fixed operating position and said open position to pivotal motion about said pivot axis.

7. The apparatus of one of the preceding claims in which said heater (13') is distributed coaxially around and spaced from said reaction chamber (7') to define a first coaxial cooling airspace (51) therebetween, said heater (13') being radially air permeable to permit a radial cooling air flow therethrough;
a plenum chamber (45) extending coaxially around and spaced from said radiant heater (13') to define an outer coaxial cooling airspace (47) between; and transversely across and spaced from one end of said radiant heater (13') to form an end coaxial cooling airspace (49) radially interconnecting said inner (51) and outer (47) coaxial cooling airspaces at said one end; and
an air-cooling means (19',37',43,53) for introducing cool air into said plenum chamber (45) proximal said one end; and for exhausting heated air from said inner coaxial airspace at a distal end thereof;
whereby cool air flows into said apparatus at said one end, axially along said inner and outer coaxial cooling airspaces, radially inward from said outer (47) to said inner (51) coaxial cooling airspace through said heater (13'), and out of said apparatus at said distal end of said inner coaxial airspace (51).

8. The apparatus of claim 7 wherein said air-cooling means comprises a closed-loop air-cooling system including:
an air-to-water heat exchanger (37') coupled to said distal end of said inner coaxial airspace (51) to receive heated air therefrom, said heat exchanger being also coupled (41') to a source of cooling water; and
an air blower (19') having an inlet (39') coupled to said heat exchanger to draw cool air therefrom, and an outlet coupled to said plenum chamber (45) to supply cool air thereto.

9. The apparatus of claim 8 further comprising a tapered duct (43) interconnecting said blower outlet and said plenum chamber (45).

10. A method for epitaxial deposition onto a semiconductor substrate carried out with the apparatus of claims 1 to 9, comprising the steps of:
supporting said semiconductor substrate on a susceptor in a reaction chamber having at least a wall portion thereof which is transparent to thermal radiation within a certain region of wavelengths;
providing a thermally activated reactive gaseous atmosphere within said reaction chamber in contact with said substrate;
activating said reactive gaseous atmosphere by heating said substrate with at least one radiant heater bank which supplies thermal radiation within said certain region of wavelengths;
supporting a pair of trunnions disposed on said radiant heater bank and defining a pivot axis extending therebetween on a trunnion-engagement means for engaging said pair of trunnions and for constraining motion of said radiant heater bank between either of: a preselected fixed operating position in which said radiant heater bank radiates thermal radiation through said wall portion to heat said substrate and susceptor; and an open position in which said bank is pivoted away from said fixed operating position.

11. The method of claim 10, wherein said heading is effected by means of a heater being distributed coaxially around and spaced from said reaction chamber to define a first coaxial cooling airspace therebetween, said heater being radially air-permeable to permit a unidirectional, radial cooling air flow therethrough.

12. The method of claim 10 or 11, further comprising the steps of:
cooling said reaction chamber and heater using a cooling system comprising a plenum chamber extending coaxially around and spaced from said radiant heater to define an outer coaxial cooling airspace therebetween; and transversely across and spaced from one end of said radiant heater to form an end coaxial cooling airspace radially interconnecting said inner and outer coaxial cooling airspaces at said one end;
introducing cool air into said plenum chamber proximal said one end; and
exhausting heated air from said inner coaxial airspace at a distal end thereof;
whereby cool air flows into said apparatus at said one end, axially along said inner and outer coaxial cooling airspaces, radially inward from said outer to said inner coaxial cooling airspace through said heater and out of said apparatus at said distal end of said inner coaxial airspace.

## Patentansprüche

1. Vorrichtung zur epitaktischen Abscheidung (1'), in Kombination umfassend:
eine Reaktionskammer (7') als Behältnis eines auf einem Aufnehmer (5) aufliegenden Halbleitersubstrats (3) und zur Aufnahme eines thermisch aktivierten, reaktiven Gases darin, wobei zumindest ein Wandabschnitt der Reaktionskammer aus einem Material gefertigt ist, welches im wesentlichen durchlässig gegenüber Wärmestrahlung innerhalb eines bestimmten Wellenlängenbereichs ist;
eine Strahlenheizung (13') zur Lieferung von Wärmestrahlen innerhalb der bestimmten Wellenlängenbereiche zur Beheizung des Substrats (3) und des Aufnehmers (5), wobei die Heizung (13') koaxial um die Reaktionskammer (7') herum und im Abstand zu dieser angeordnet ist, um einen ersten koaxialen Kühlluftraum (51) dazwischen zu schaffen, wobei die Heizung (13') radial luftdurchlässig ist, um einen radialen, in einer Richtung fließenden Kühlluftstrom durch sich zu ermöglichen, und wobei die Strahlenheizung (13') zumindest eine Strahlungsheizungsbank (55) enthält; und
Halterungsmittel (61, 63), umfassend:
ein Paar Drehzapfen (59), die an der Strahlungsheizungsbank (55) angebracht sind und eine sich dazwischen erstreckende Drehachse bilden;
Drehachsenverankerungsmittel (85, 87) zur Verankerung des Drehzapfenpaars (59) und zur Einschränkung der Bewegung der Heizungsbank (55) zwischen einer vorbestimmten, festen Betriebsstellung, in der die Strahlungsheizungsbank (55) Wärmestrahlung durch den Wandabschnitt sendet, um das Substrat (3) und den Aufnehmer (5) in der Reaktionskammer (7') zu erwärmen und in der ein Luftraum (51) zwischen der Reaktionskammer (7') und der Heizung (13') geschaffen wird, um einen Luftstrom zur Kühlung der Wand zu ermöglichen, und einer offenen Stellung, in der die Bank um die Drehachse aus der festen Betriebsstellung heraus geschwenkt wird; und
Halterungsmittel (83) zur Parallelbewegung der Bank (55) und zur Beschränkung dieser Parallelbewegung entlang einer Parallelbewegungsachse aus der offenen Stellung in eine gelöste Stellung, in der die Bank (55) unbelastet von den restlichen Teilen der Vorrichtung angehoben werden kann, und zur kontinuierlichen Unterstützung der Bank (55) während der Parallelbewegung zwischen der offenen und der gelösten Stellung.

2. Vorrichtung nach Anspruch 1, wobei die Heizung (13') mehrere Strahlungsheizungsbänke (55) umfaßt, die nebeneinander angeordnet sind.

3. Vorrichtung nach Anspruch 2, wobei die Heizungsbänke in einer Fläche und so angeordnet sind, daß sie ein Vieleck bilden, in dessen Mitte sich die Reaktionskammer (7') befindet.

4. Vorrichtung nach einem der Ansprüche 1 bis 3, ferner umfassend:
Verriegelungsmittel (65) zur Sicherung der Bank (55) in der festen Betriebsstellung, wobei die Verriegelungsmittel (65) wahlweise bedienbar sind zwischen einer Verriegelungsstellung, in der die Bank (55) in der festen Betriebsstellung verriegelt ist, und einer gelösten Stellung, in der die Bank (55) aus der Betriebsstellung in die offene Stellung beweglich ist.

5. Vorrichtung nach einem der Ansprüche 1 bis 4, wobei die Aufnahmemittel (61, 63) die Bank (55) während der Bewegung zwischen der Betriebs- und der offenen Stellung kontinuierlich halten.

6. Vorrichtung nach einem der Ansprüche 1 bis 3, wobei die Aufnahmemittel (61, 63) die Bewegung der Heizungsbank (55) zwischen der festen Betriebsstellung und der offenen Stellung auf eine Drehbewegung um die Drehachse beschränkt.

7. Vorrichtung nach einem der vorangehenden Ansprüche, in der die Heizung (13') koaxial um die Reaktionskammer (7') und in einem Abstand zu dieser angeordnet ist, um einen ersten koaxialen Kühlluftraum (51) zwischen diesen zu bilden, wobei die Heizung (13') radial luftdurchlässig ist, um einen radialen Kühlluftstrom durch sie hindurch zu ermöglichen;
eine Plenumkammer (45), die sich koaxial um die Strahlungsheizung (13') und in einem Abstand zu dieser erstreckt, um einen äußeren koaxialen Kühlluftraum (47) zwischen diesen zu schaffen, und die sich des weiteren quer über ein Ende der Strahlungsheizung (13') und in einem Abstand zu diesem erstreckt, um einen endseitigen, koaxialen Kühlluftraum (49) zu bilden, der den inneren (51) und den äußeren (47) koaxialen Kühlluftraum an diesem Ende radial verbindet; und
Luftkühlungsmittel (19', 37', 43, 53) zur Einleitung von kühler Luft in die Plenumkammer (45) in der Nähe des einen Endes, sowie zur Ableitung erhitzter Luft aus dem inneren koaxialen Luftraum an einem entfernten Ende derselben;
wobei in die Vorrichtung an dem einem Ende kühle Luft einfließt, axial entlang der inneren und äußeren koaxialen Lufträume, radial nach innen von dem äußeren (47) in den inneren (51) koaxialen Kühlluftraum durch die Heizung (13') und aus der Vorrichtung heraus an dem entfernten Ende des inneren koaxialen Luftraums (51).

8. Vorrichtung nach Anspruch 7, wobei die Luftkühlungsmittel ein geschlossenes Luftkühlungssystem umfassen, welches seinerseits die folgenden Elemente umfaßt:
einen Luft-Wasser-Wärmetauscher (37'), der an das entfernte Ende des inneren koaxialen Luftraums (51) zur Aufnahme geheizter Luft aus demselben angeschlossen ist, wobei der Wärmetauscher auch an eine Kühlwasserquelle angeschlossen (41') ist; und
ein Luftgebläse (19') mit einem Einlaß (39'), der an den Wärmetauscher angeschlossen ist, um aus diesem kühle Luft zu beziehen, sowie mit einem Auslaß, welcher an die Plenumkammer (45) angeschlossen ist, um diese mit kühler Luft zu versorgen.

9. Vorrichtung nach Anspruch 8, ferner umfassend eine konische Leitung (43), welche den Gebläseauslaß und die Plenumkammer (45) miteinander verbindet.

10. Verfahren zur epitaktischen Abscheidung auf ein Halbleitersubstrat, ausgeführt auf der Vorrichtung nach Anspruch 1 bis 9, umfassend die folgenden Schritte:
Befestigung des Halbleitersubstrats auf einem Aufnehmer in einer Reaktionskammer, die zumindest einen für Wärmestrahlung in einem bestimmten Wellenlängenbereich durchlässigen Wandabschnitt aufweist;
Bereitstellung einer thermisch aktivierten, reaktiven, gasförmigen Atmosphäre im Inneren der Reaktionskammer, die sich im Kontakt mit dem Substrat befindet;
Aktivierung der reaktiven, gasförmigen Atmosphäre durch Erhitzen des Substrats mit zumindest einer Strahlungsheizungsbank, welche Wärmestrahlung innerhalb des bestimmten Wellenlängenbereichs liefert;
Unterstützung eines Paares von Drehzapfen, die an der Strahlungsheizungsbank angebracht sind und eine sich zwischen denselben erstreckende Drehachse bilden, auf Drehzapfenaufnahmemitteln zur Aufnahme des Drehzapfenpaares und zur Beschränkung der Bewegung der Strahlungsheizungsbank zwischen entweder einer vorbestimmten, festen Betriebsstellung, in der die Strahlungsheizungsbank zur Erwärmung des Substrats und des Aufnehmers Wärmestrahlung durch den Wandabschnitt abgibt, oder einer offenen Stellung, in der die Bank von der festen Betriebsstellung weggeschwenkt ist.

11. Verfahren nach Anspruch 10, wobei die Erwärmung durch eine Heizung bewirkt wird, die koaxial um die Reaktionskammer und in einem Abstand zu dieser angeordnet ist, um einen ersten koaxialen Kühlluftraum dazwischen zu bilden, wobei die Heizung radial luftdurchlässig ist, um einen in einer Richtung verlaufenden, radialen Kühlluftstrom durch sie hindurch zu ermöglichen.

12. Verfahren nach Anspruch 10 oder 11, ferner umfassend die folgenden Schritte:
Kühlung der Reaktionskammer und der Heizung unter Verwendung eines Kühlsystems, das eine Plenumkammer umfaßt, welche sich koaxial um und in einem Abstand von der Strahlungsheizung erstreckt, um einen äußeren koaxialen Kühlluftraum dazwischen zu bilden, und welche sich des weiteren quer über und in einem Abstand von einem Ende der Strahlungsheizung erstreckt, um einen endseitigen koaxialen Kühlluftraum zu bilden, der den inneren und den äußeren koaxialen Kühlluftraum an dem einen Ende radial verbindet;
Einführung kühler Luft in die Plenumkammer in der Nähe der einen Seite; und
Ableitung erhitzter Luft aus dem inneren koaxialen Luftraum an einem entfernten Ende derselben;
wobei in die Vorrichtung an dem einen Ende kühle Luft einfließt und weiter axial entlang dem inneren und dem äußeren koaxialen Kühlluftraum, radial nach innen von dem äußeren in den inneren koaxialen Kühlluftraum durch die Heizung, und aus der Vorrichtung am entfernten Ende des inneren koaxialen Luftraums wieder hinaus.

## Revendications

1. Appareil de dépôt épitaxial (1') comprenant en combinaison :
une chambre de réaction (7') destinée à contenir un substrat de semi-conducteur (3) supporté sur un suscepteur (5) et à confiner un gaz réactif activé thermiquement à l'intérieur de celle-ci, ladite chambre de réaction ayant au moins une portion de paroi constituée d'un matériau qui est sensiblement transparent au rayonnement thermique dans un certain domaine de longueurs d'onde ;
un dispositif de chauffage par rayonnement (13') pour générer un rayonnement thermique dans ledit certain domaine de longueurs d'onde, afin de chauffer ledit substrat (3) et ledit suscepteur (5) ; lequel dispositif de chauffage (13') est distribué coaxialement autour de, et espacé de, ladite chambre de réaction (7') pour définir un premier espace d'air de refroidissement coaxial (51) entre ceux-ci, ledit dispositif de chauffage (13') étant radialement perméable à l'air pour permettre un écoulement d'air de refroidissement unidirectionnel, radial, à travers celui-ci, ledit dispositif de chauffage par rayonnement (13') comprenant au moins un banc de chauffage par rayonnement (55) ; et
des moyens de support (61,63) comprenant :
une paire de tourillons (59) disposés sur ledit banc de chauffage par rayonnement (55) et définissant un axe de pivotement qui s'étend entre ceux-ci ;
des moyens de venue en prise avec les tourillons (85,87) pour venir en prise avec ladite paire de tourillons (59) et pour limiter le déplacement dudit banc de chauffage (55) entre une position opératoire fixe présélectionnée, dans laquelle ledit banc de chauffage par rayonnement (55) émet un rayonnement thermique à travers ladite portion de paroi pour chauffer ledit substrat (3) et ledit suscepteur (5) dans ladite chambre de réaction (7') et dans laquelle un espace d'air (51) est prévu entre ladite chambre de réaction (7') et ledit dispositif de chauffage (13') pour permettre à un courant d'air de refroidir ladite paroi ; et une position ouverte, dans laquelle ledit banc est déplacé par pivotement autour dudit axe de pivotement, à l'écart de ladite position opératoire fixe ; et
des moyens de support en translation (83) pour déplacer par translation ledit banc (55) et pour limiter ledit déplacement par translation le long d'un axe de translation depuis ladite position ouverte vers une position de libération, dans laquelle ledit banc (55) peut être dégagé, en le soulevant, des portions restantes de l'appareil ; et pour supporter en continu ledit banc (55) au cours du déplacement par translation entre lesdites positions ouverte et de libération.

2. Appareil selon la revendication 1, dans lequel le dispositif de chauffage (13') est constitué de plusieurs bancs de chauffage par rayonnement (55) disposés adjacents les uns aux autres.

3. Appareil selon la revendication 2, dans lequel les bancs de chauffage sont plans et disposés en forme de polygône, la chambre de réaction (7') étant disposée au centre de celui-ci.

4. Appareil selon l'une des revendications 1 à 3, comprenant en outre :
des moyens de verrouillage (65) pour fixer ledit banc (55) dans ladite position opératoire fixe, lesdits moyens de verrouillage (65) pouvant être actionnés sélectivement entre une position de verrouillage dans laquelle ledit banc (55) est verrouillé dans ladite position opératoire fixe et une position de libération dans laquelle ledit banc (55) est susceptible de se déplacer à l'écart de ladite position opératoire vers ladite position ouverte.

5. Appareil selon l'une des revendications 1 à 4, dans lequel lesdits moyens de support (61,63) supportent ledit banc (55) en continu au cours du déplacement entre lesdites positions opératoire et ouverte.

6. Appareil selon l'une des revendications 1 à 3, dans lequel lesdits moyens de support (61,63) limitent le déplacement dudit banc de chauffage (55) entre ladite position opératoire fixe et ladite position ouverte à un déplacement par pivotement autour dudit axe de pivotement.

7. Appareil selon l'une des revendications précédentes, dans lequel ledit dispositif de chauffage (13') est distribué coaxialement autour de, et espacé de, ladite chambre de réaction (7') pour définir un premier espace d'air de refroidissement coaxial (51) entre ceux-ci, ledit dispositif de chauffage (13') étant radialement perméable à l'air pour permettre un écoulement d'air de refroidissement radial à travers celui-ci ;
une chambre de circulation d'air (45) s'étendant coaxialament autour du, et étant espacée du, dispositif de chauffage par rayonnement (13') pour définir un espace d'air de refroidissement coaxial externe (47) entre ceux-ci ;
et s'étendant transversalement d'un bout à l'autre et à l'écart d'une extrémité dudit dispositif de chauffage par rayonnement (13') pour former un espace d'air de refroidissement coaxial terminal (49) interconnectant radialement lesdits espaces d'air de refroidissement coaxiaux interne (51) et externe (47) au niveau de ladite extrémité ; et
des moyens de refroidissement à l'air (19', 37', 43, 53) étant prévus pour introduire de l'air frais dans ladite chambre de circulation d'air (45) à proximité de ladite extrémité ; et pour rejeter l'air chauffé depuis ledit espace d'air coaxial interne à une extrémité distale de celui-ci ;
grâce à quoi l'air frais s'écoule dans ledit appareil à ladite extrémité, axialement le long desdits espaces d'air de refroidissement coaxiaux interne et externe, radialement vers l'intérieur depuis ledit espace d'air de refroidissement coaxial externe (47) vers ledit espace d'air de refroidissement coaxial interne (51), a travers ledit dispositif de chauffage (13') et hors dudit appareil à ladite extrémité distale dudit espace d'air coaxial interne (51).

8. Appareil selon la revendication 7, dans lequel lesdits moyens de refroidissement à l'air sont constitués par un système de refroidissement à l'air à boucle fermée comprenant :
un échangeur thermique air-vers-eau (37') couplé à ladite extrémité distale dudit espace d'air coaxial interne (51) pour recevoir de l'air chauffé depuis celui-ci, ledit échangeur thermique étant également couplé (41') à une source d'eau de refroidissement ; et
une souffleuse d'air (19') pourvue d'une entrée (39') couplée audit échangeur thermique pour extraire l'air frais de celui-ci et une sortie couplée à ladite chambre de circulation d'air (45) pour fournir de l'air frais à celle-ci.

9. Appareil selon la revendication 8, comprenant en outre une conduite effilée (43) interconnectant ladite sortie de souffleuse à ladite chambre de circulation d'air (45).

10. Procédé de dépôt épitaxial sur un substrat de semi-conducteur mis en oeuvre avec l'appareil selon les revendications 1 à 9, comprenant les étapes consistant à :
supporter ledit substrat de semi-conducteur sur un suscepteur dans une chambre de réaction pourvue d'au moins une portion de paroi qui est transparente au rayonnement thermique dans un certain domaine de longueurs d'onde ;
fournir une atmosphère gazeuse réactive, activée thermiquement, à l'intérieur de ladite chambre de réaction, en contact avec ledit substrat ;
activer ladite atmosphère gazeuse réactive en chauffant ledit substrat à l'aide d'au moins un banc de chauffage par rayonnement qui génère un rayonnement thermique dans ledit certain domaine de longueurs d'onde ;
supporter une paire de tourillons, disposés sur ledit banc de chauffage par rayonnement et définissant un axe de pivotement s'étendant entre ceux-ci, sur un moyen de venue en prise avec les tourillons qui vient en prise avec ladite paire de tourillons et limite le déplacement dudit banc de chauffage par rayonnement entre soit une position opératoire fixe présélectionnée dans laquelle ledit banc de chauffage par rayonnement émet un rayonnement thermique à travers ladite portion de paroi pour chauffer ledit substrat et ledit suscepteur, soit une position ouverte dans laquelle ledit banc est écarté par pivotement de ladite position opératoire fixe.

11. Procédé selon la revendication 10, dans lequel ledit chauffage est effectué au moyen d'un dispositif de chauffage qui est distribué coaxialement autour de, et espacé de, ladite chambre de réaction pour définir un premier espace d'air de refroidissement coaxial entre ceux-ci, ledit dispositif de chauffage étant radialement perméable à l'air pour permettre un écoulement d'air de refroidissement radial unidirectionnel à travers celui-ci.

12. Procédé selon la revendication 10 ou 11, comprenant en outre les étapes consistant à :
refroidir ladite chambre de réaction et ledit dispositif de chauffage en utilisant un système de refroidissement constitué par une chambre de circulation d'air qui s'étend coaxialement autour du, et est espacée du, dispositif de chauffage par rayonnement pour définir un espace d'air de refroidissement coaxial externe entre ceux-ci ; et qui s'étend transversalement d'un bout à l'autre et à l'écart d'une extrémité dudit dispositif de chauffage par rayonnement pour former un espace d'air de refroidissement coaxial terminal, interconnectant radialement lesdits espaces d'air de refroidissement coaxiaux interne et externe au niveau de ladite extrémité ;
introduire de l'air frais dans ladite chambre de circulation d'air à proximité de ladite extrémité ;
rejeter l'air chauffé depuis ledit espace d'air coaxial interne à une extrémité distale de celui-ci ;
grâce à quoi l'air frais s'écoule dans ledit appareil à ladite extrémité, axialement le long desdits espaces d'air de refroidissement coaxiaux interne et externe, radialement vers l'intérieur depuis ledit espace d'air de refroidissement coaxial externe vers ledit espace d'air de refroidissement coaxial interne, à travers ledit dispositif de chauffage, et hors dudit appareil à l'extrémité distale dudit espace d'air coaxial interne.
